(19) Europäisches Patentamt

European Patent Office

Office européen des brevets

(11) **EP 1 011 136 A1**

(12) **DEMANDE DE BREVET EUROPEEN**

(43) Date de publication:
**21.06.2000 Bulletin 2000/25**

(51) Int Cl.⁷: **H01L 21/768**

(21) Numéro de dépôt: **99403122.7**

(22) Date de dépôt: **13.12.1999**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **14.12.1998 FR 9815769**

(71) Demandeurs:
• **STMicroelectronics SA**
**94250 Gentilly (FR)**
Etats contractants désignés:
**AT BE CH CY DE DK ES FI FR GB GR IE IT LI LU MC NL PT SE**
• **FRANCE TELECOM**
**75015 Paris (FR)**
Etats contractants désignés:
**FR**

(72) Inventeurs:
• **Schoellkopf, Jean-Pierre**
**38000 Grenoble (FR)**
• **Gayet, Philippe**
**38660 St. Vincent de Mercuze (FR)**

(74) Mandataire: **Casalonga, Axel**
**BUREAU D.A. CASALONGA - JOSSE**
**Morassistrasse 8**
**80469 München (DE)**

(54) **Procédé de réalisation d'une résistance dans un circuit intégré et dispositif intégré correspondant de mémoire vive statique à quatre transistors et deux résistances**

(57)     Dans le dispositif intégré de mémoire vive statique à quatre transistors et deux résistances, les quatre transistors sont réalisés dans un substrat semi-conducteur et mutuellement interconnectés par une couche d'interconnexion locale (M0) située sous un premier niveau de métallisation (M1) et formant au dessus du substrat un niveau de métallisation de base (M0). Les deux résistances s'étendent au contact d'une partie (LIL1, LIL2) de la couche d'interconnexion locale entre le niveau de métallisation de base (M0) et le premier niveau de métallisation (M1).

FIG.5

## Description

L'invention concerne la réalisation d'un circuit intégré comprenant une résistance disposée entre deux niveaux de métallisation de ce circuit intégré, et trouve une application particulièrement avantageuse mais non limitative aux mémoires vives statiques dont chaque cellule ou point mémoire est réalisé par quatre transistors et deux résistances.

Un but de l'invention est d'utiliser la place disponible entre les connexions verticales existant déjà entre deux niveaux de métallisation pour y insérer la résistance.

L'invention a également pour but de réaliser de façon particulièrement simple, des résistances de valeur élevée.

L'invention a encore pour but, notamment dans le cas d'une application aux mémoires vives statiques, de réaliser un point mémoire particulièrement dense.

L'invention propose donc tout d'abord un procédé de réalisation d'un circuit intégré comprenant une résistance disposée entre deux niveaux de métallisation du circuit intégré. Selon ce procédé, on réalise sur le niveau de métallisation inférieur un niveau de métallisation dit intermédiaire, comportant une couche électriquement conductrice, dont la face inférieure d'une première partie repose au-dessus d'une portion d'une piste métallique du niveau de métallisation inférieur par l'intermédiaire d'une fine couche d'un matériau diélectrique de façon à former au moins une première partie de ladite résistance, cette couche conductrice étant entourée latéralement d'une couche isolante dite intermédiaire. On dépose sur le niveau de métallisation intermédiaire une couche isolante supérieure supportant le niveau de métallisation supérieur, et on réalise une connexion métallique (ou "via") reliant la deuxième partie de la couche conductrice à une piste du niveau de métallisation supérieur.

La portion de couche diélectrique prise en sandwich entre la face inférieure de la première partie de la couche électriquement conductrice et la portion de la piste métallique du niveau de métallisation inférieur, forme le diélectrique d'une capacité dont les deux électrodes sont respectivement formées de la première partie de la couche conductrice et de ladite portion de piste métallique. Or, la faible épaisseur de cette couche diélectrique, comparée à l'épaisseur de la couche conductrice et à celle de la portion métallique, conduit à l'obtention d'une capacité de faible valeur qui fuit lors de l'application d'une différence de potentiel à ses bornes, et qui se comporte donc comme une résistance de valeur élevée.

Dans une première variante de l'invention, les première et deuxième parties de la couche électriquement conductrice sont identiques et on réalise la connexion métallique en gravant la couche isolante supérieure avec arrêt sur la face supérieure de la deuxième partie de la couche conductrice. En d'autres termes, cette variante permet la réalisation de résistances verticales particulièrement compactes.

Une autre variante consiste à déporter la deuxième partie de la couche conductrice par rapport à la première partie.

A partir de là, une première possibilité prévoit la réalisation de la connexion métallique en gravant la couche isolante supérieure avec arrêt sur la face supérieure de la deuxième partie de la couche conductrice. Une telle variante permet donc de connecter le niveau de métal supérieur quand la réalisation d'une résistance verticale n'est pas possible.

Une autre possibilité prévoit le contact de la face inférieure de la deuxième partie de la couche conductrice sur la couche diélectrique au-dessus d'une portion d'une autre piste métallique du niveau inférieur, de façon à former une deuxième partie de la résistance électriquement reliée à la première partie par le reste de la couche conductrice. Ainsi, on forme deux résistances en série. Si besoin, la connexion avec le niveau de métallisation supérieur se fait par une connexion métallique en contact avec une autre portion de cette autre piste métallique du niveau inférieur.

Bien que la réalisation du niveau de métallisation intermédiaire puisse s'effectuer de différentes façons, il est particulièrement avantageux de réaliser ce niveau de métallisation par un procédé bien connu de l'homme du métier dit "procédé damascène". En d'autres termes, la réalisation du niveau de métallisation intermédiaire comprend le dépôt de la couche isolante intermédiaire, la gravure de cette couche isolante de façon à définir une cavité à l'emplacement de la couche conductrice, puis le dépôt de la couche diélectrique sur les parois et le fond de la cavité. On remplit alors ladite cavité avec un matériau électriquement conducteur de façon à former ladite couche conductrice.

Lorsque le niveau de métallisation inférieur est un niveau de métal 0, encore appelé par l'homme du métier "couche locale d'interconnexion", l'invention s'applique particulièrement bien à la réalisation de points-mémoire à quatre transistors et deux résistances, formant une mémoire vive statique.

Plus précisément, l'invention propose également un tel dispositif intégré de mémoire vive statique à quatre transistors et deux résistances, dans lequel les quatre transistors sont réalisés dans un substrat semi-conducteur et mutuellement interconnectés par une couche d'interconnexion locale située sous un premier niveau de métallisation (métal 1) et formant au-dessus du substrat un niveau de métallisation de base (métal 0). Les deux résistances s'étendent alors au contact d'une partie de la couche d'interconnexion locale entre le niveau de métallisation de base (métal 0) et le premier niveau de métallisation (métal 1).

L'invention permet donc l'obtention de points-mémoire particulièrement denses, ce qui minimise considérablement la surface d'une mémoire vive statique incorporant un très grand nombre de ces points mémoire.

Plusieurs possibilités sont offertes pour la formation de chacune des résistances de ce point mémoire. On peut former chaque résistance à partir d'une couche d'un matériau résistif reposant à ses deux extrémités sur deux portions de la couche d'interconnexion locale.

Il est également possible, en variante, que chaque résistance soit formée d'une couche d'un matériau électriquement conducteur reposant à ses deux extrémités sur deux portions de la couche d'interconnexion locale, et de deux fines couches d'un matériau diélectrique respectivement disposées aux deux extrémités de la couche électriquement conductrice entre cette couche électriquement conductrice et la portion correspondante de la couche d'interconnexion locale.

Quelle que soit la ou les variantes utilisées, éventuellement en combinaison, selon un mode de réalisation de l'invention, chaque résistance s'appuie sur une première portion de couche d'interconnexion locale réalisant l'interconnexion entre la grille d'un transistor de mémorisation et le drain de l'autre transistor de mémorisation, et sur une deuxième portion de couche d'interconnexion locale reliée au premier niveau de métallisation par un trou d'interconnexion métallique. La forme de chaque résistance épouse alors partiellement celle de la grille dudit transistor de mémorisation.

D'autres avantages et caractéristiques de l'invention apparaîtront à l'examen de la description détaillée de modes de mise en oeuvre et de réalisation nullement limitatifs, et des dessins annexés, sur lesquels :

- les figures 1 à 3 illustrent trois variantes de réalisation d'une résistance intercalée entre deux niveaux de métallisation adjacents d'un circuit intégré; et
- les figures 4 à 6 illustrent une application de l'invention plus particulièrement dirigée sur la réalisation d'une cellule de mémoire vive statique à quatre transistors et deux résistances.

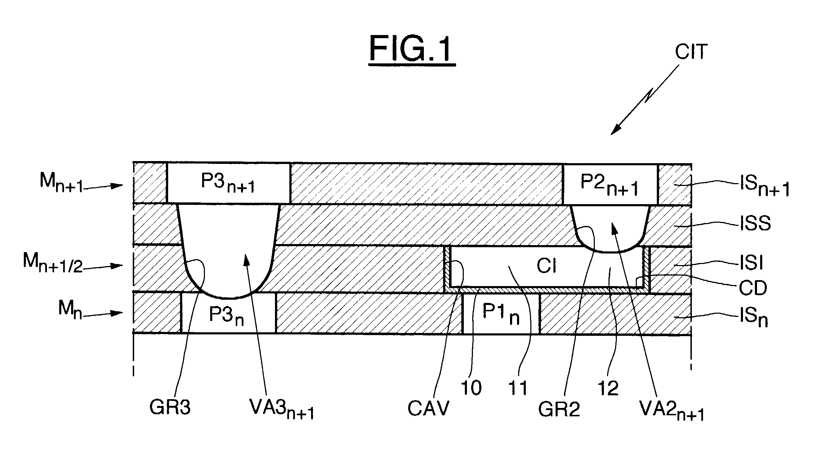

Sur la figure 1, la référence CIT désigne d'une façon générale un circuit intégré au sein duquel on a réalisé, de façon classique et connue en soi, un niveau de métallisation $M_n$ (métal n) comportant des pistes métalliques $P1_n$ et $P3_n$ mutuellement isolées par une couche d'isolant $IS_n$, par exemple du dioxyde de silicium ayant typiquement une épaisseur de 200 nm.

On va ensuite réaliser un niveau de métallisation intermédiaire que l'on dénomme ici $M_{n+1/2}$.

Ce niveau de métallisation intermédiaire comporte une couche électriquement conductrice CI, par exemple en tungstène, en aluminium ou en cuivre, entourée d'une couche isolante, dite "couche isolante intermédiaire ISI". Il est particulièrement avantageux de réaliser cette couche conductrice CI par un procédé bien connu de l'homme du métier dit "procédé damascène". Ce procédé consiste à déposer tout d'abord la couche isolante intermédiaire ISI, par exemple du dioxyde de silicium d'une épaisseur de 300 nm, puis à graver, en utilisant un masque spécifique de gravure, une cavité CAV dans cette couche ISI à l'emplacement de laquelle va être réalisée la couche conductrice CI. On dépose ensuite sur la couche ISI et dans la cavité CAV une fine couche diélectrique CD par un procédé connu en soi, puis le matériau électriquement conducteur. On effectue enfin un polissage mécanochimique pour planéifier la surface supérieure de cette couche CI.

La couche CD est alors supprimée à l'extérieur de la cavité CAV par ce polissage.

Cette couche diélectrique CD a par exemple une épaisseur de quelques nanomètres, voire une dizaine de nanomètres, et peut être par exemple constituée du même matériau que celui de la couche isolante $IS_n$, à savoir du dioxyde de silicium. Ceci étant, on pourrait utiliser d'autres matériaux diélectriques, comme par exemple le nitrure de silicium, ou du $Ta_2O_5$.

Il aurait été possible de réaliser cette couche CI par un autre procédé, à savoir le dépôt de la couche CD puis d'une couche métallique sur la totalité du métal n, puis la gravure de cette couche métallique de façon à former la couche CI, et enfin le dépôt de la couche isolante ISI. Cependant, le procédé damascène présente l'avantage de ne pas altérer la couche diélectrique CD lors de la réalisation du niveau de métallisation n+1/2.

On dépose ensuite une autre couche isolante, dite "couche isolante supérieure ISS", ayant également une épaisseur typiquement de l'ordre de 300 nm. Puis on réalise, à l'aide d'un masque classique, la gravure des couches isolantes ISS, ISI et CD de façon à former des cavités respectives GR3 et GR2 qui seront remplies ultérieurement d'un métal de remplissage (par exemple du tungstène), afin de réaliser des connexions métalliques verticales, communément appelés par l'homme du métier "vias".

Ainsi, une fois le niveau de métallisation supérieur $M_{n+1}$ effectué de façon connue en soi (métal n+1), le via $VA3_{n+1}$ va réaliser l'interconnexion métallique entre la piste $P3_n$ du métal n et la piste $P3_{n+1}$ du métal n+1. De même, le via $VA2_{n+1}$ va réaliser l'interconnexion entre la couche conductrice CI et la piste $P2_{n+1}$ du métal n+1. Bien entendu, l'ensemble des pistes du niveau de métal n+1 sont isolées mutuellement par un isolant $IS_{n+1}$.

L'homme du métier remarque que la première partie 11 de la couche conductrice CI, située à gauche de celle-ci sur la figure 1, forme avec la portion de la piste métallique $P1_n$ qui lui fait face, deux électrodes d'une capacité dont le diélectrique est la portion 10 de couche CD située entre ces deux électrodes. Or, compte tenu du rapport entre l'épaisseur de la couche diélectrique et l'épaisseur des niveaux de métallisation $M_n$ et $M_{n+1/2}$, cette capacité présente une faible valeur et a en outre la particularité de fuir sous l'application d'une différence de potentiel entre les pistes $P2_{n+1}$ et $P1_n$. Cette

faible capacité fuyante se comporte alors comme une résistance R de valeur particulièrement élevée. Ainsi, avec les valeurs numériques indiquées ci-avant, on obtient des courants de fuite de l'ordre de $10^{-9}$ A sous 1 Volt, ce qui conduit à l'obtention d'une valeur résistive aussi élevée que $10^9$ Ohm. Bien entendu, l'homme du métier saura aisément ajuster les valeurs du rapport entre l'épaisseur du diélectrique et l'épaisseur des électrodes de façon à ajuster la valeur de la résistance au niveau souhaité en fonction des matériaux utilisés.

L'homme du métier remarque également que la réalisation de la résistance R a nécessité uniquement un seul masque supplémentaire, à savoir celui nécessaire pour la gravure de la cavité CAV aux fins de formation de la couche CI. Les autres vias du circuit intégré ont été réalisés à l'aide des masques habituels de contact.

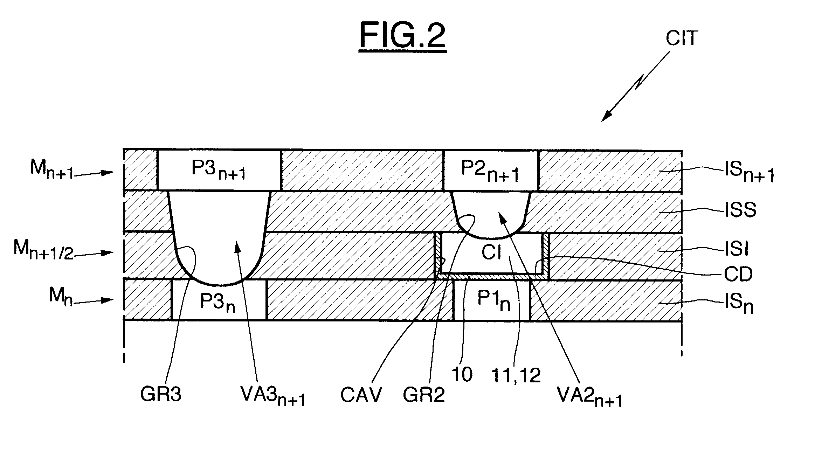

Alors que sur la figure 1, la deuxième partie 12 de la couche conductrice CI sur la surface supérieure de laquelle vient contacter le via $VA2_{n+1}$, est déportée par rapport à la première partie 11, ces deux parties 11 et 12 sont identiques sur la figure 2.

Sur cette figure 2, on voit que la résistance R, formée par la capacité fuyante correspondante, présente un encombrement particulièrement réduit en raison de sa connexion verticale au niveau de métallisation $M_{n+1}$ par l'intermédiaire du via $VA2_{n+1}$. En outre, il convient de remarquer ici que lors de la gravure de la cavité GR2 du via $VA2_{n+1}$, la couche conductrice CI sert de masque pour protéger la couche diélectrique CD. La couche conductrice CI possède donc ici plusieurs fonctions, à savoir une fonction électrique de formation de l'une des électrodes de la capacité, une fonction de connexion électrique avec le via $VA2_{n+1}$ et une fonction de masque pour la protection de la couche diélectrique CD lors de la gravure de la cavité GR2 avant remplissage par le tungstène pour former le via $VA2_{n+1}$.

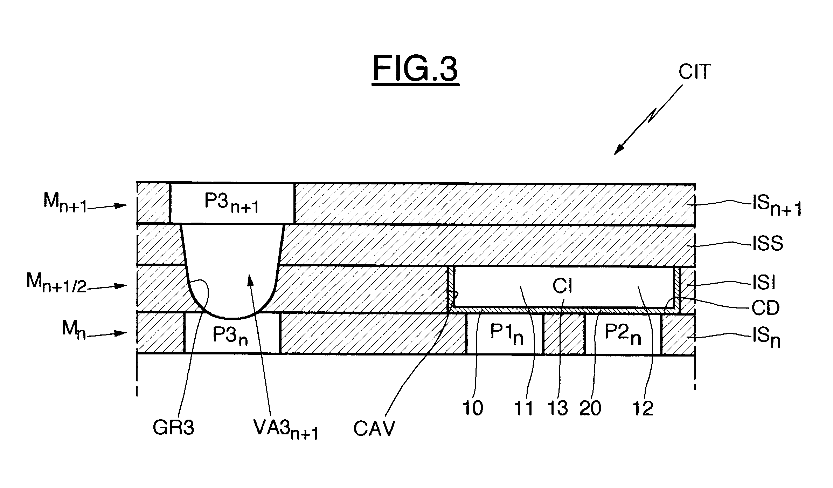

La variante de réalisation illustrée sur la figure 3 correspond à un cas de figure où la connexion de la couche conductrice CI n'est pas directement possible, au-dessus de la couche CI, vers le niveau de métallisation $M_{n+1}$. Dans ce cas, la deuxième partie 12 de la couche conductrice CI, qui est déportée par rapport à la première partie 11, contacte également une autre portion d'une autre piste métallique $P2_n$ du niveau de métallisation $M_n$ par l'intermédiaire d'une autre partie 20 de la couche diélectrique CD.

L'homme du métier remarque donc que l'on a réalisé ici en fait deux résistances respectivement formées par une première capacité (partie 11 de la couche CI, portion 10 de la couche CD et portion de la piste métallique $P1_n$) et par une deuxième capacité (partie 12 de la couche CI, portion 20 de la couche CD et portion de la piste métallique $P2_n$). Ces deux résistances sont électriquement reliées par le reste 13 de la couche CI. Si R1 et R2 désignent les valeurs résistives des deux résistances ainsi formées, la structure décrite sur la figure 3 est donc équivalente à une résistance de valeur R1 + R2 connectée entre les deux pistes $P1_n$ et $P2_n$.

La connexion au niveau de métallisation $M_{n+1}$ si besoin, peut se faire en réalisant un via entre par exemple une autre portion de la piste métallique $P2_n$ (non représentée ici sur cette figure) et une piste métallique du niveau de métal n+1.

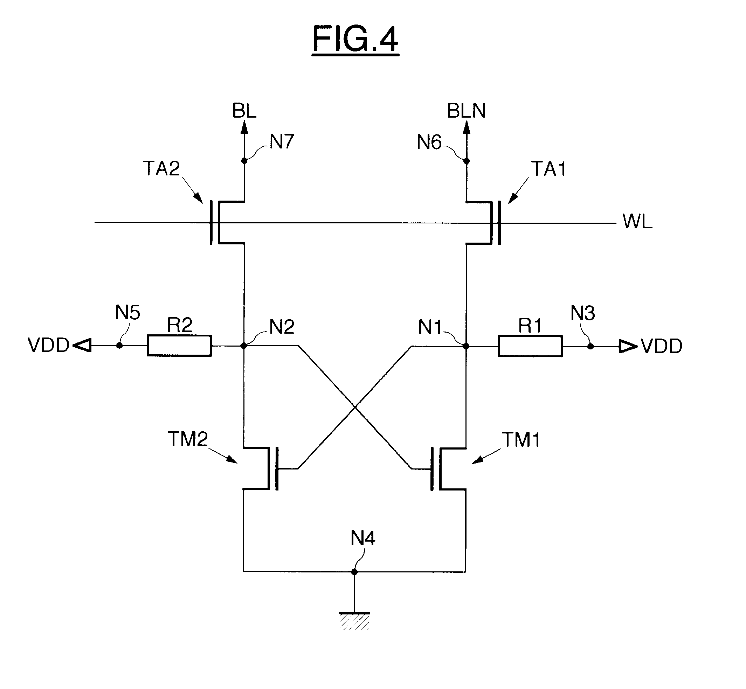

La réalisation d'une telle résistance trouve une application particulièrement avantageuse dans la réalisation d'un point mémoire à quatre transistors et deux résistances tel que celui illustré sur la figure 4.

Plus précisément, ce point mémoire ou cellule mémoire comporte deux transistors de mémorisation TM1 et TM2, la grille de l'un des transistors de mémorisation étant reliée au drain de l'autre transistor de mémorisation. Les sources des deux transistors de mémorisation sont reliées à la masse (noeud N4).

Les drains des transistors TM1 et TM2 (noeud N1 et noeud N2) sont respectivement reliés aux sources des transistors d'accès TA1 et TA2, qui sont eux-mêmes reliés (noeud N6 et noeud N7) à une ligne de bit BL ("$\overline{\text{bit-line}}$" en langue anglaise) et à la ligne de bit complémentaire BLN (bit-line). Les grilles des transistors d'accès TA1 et TA2 sont commandées par la ligne de mots WL (world line).

Enfin, deux résistances R1 et R2 sont respectivement reliées aux noeuds N1 et N2 ainsi qu'au niveau d'alimentation VDD (noeuds N3 et N5).

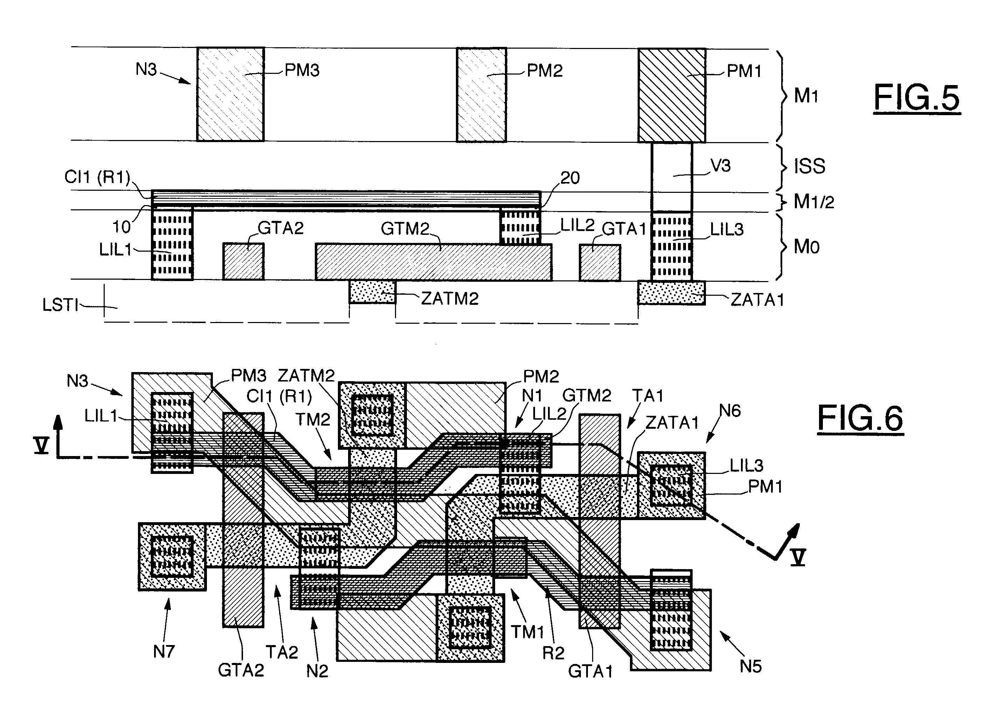

Comme on peut le voir sur le schéma de placement simplifié de la figure 6 ainsi que sur la section selon la ligne V-V de cette figure 6 (figure 5), le niveau de métal zéro $M_0$ permet de réaliser, au moyen de portions de couches d'interconnexion locale, les différentes interconnexions entre les grilles, drains et sources des différents transistors. La référence ZATM2 désigne la zone active du transistor de mémorisation TM2 tandis que GTA2 et GTA1 désignent les grilles des transistors d'accès TA1 et TA2. STI désigne une zone d'isolement dans le substrat (par tranchée peu profonde). La portion de couche d'interconnexion locale LIL2 pemet de connecter la grille GTM2 du transistor de mémorisation TM2 avec le drain du transistor TM1. La couche locale LIL3 va contacter la zone active ZATA 1 (et plus particulièrement la source) du transistor d'accès TA 1 et va permettre en se prolongeant par un via V3 jusqu'au niveau M1 de métal, de contacter la piste PM1 (noeud N6).

De même, la couche locale LIL1 prolongée, par un autre via (non représenté sur la figure 5) jusqu'à la piste PM3 du niveau de métallisation M1, permet de se connecter au niveau d'alimentation VDD (noeud N3). La piste PM2 est connectée à la masse (source du transistor TM2) et forme le noeud N4.

La résistance R1 est formée ici d'une couche conductrice CI1 s'étendant au niveau de métallisation intermédiaire $M_{1/2}$ et reposant sur deux portions des couches LIL1 et LIL2.

Dans la variante illustrée sur ces figures, la couche CI1 repose sur les portions des couches d'interconnexion locale LIL1 et LIL2 par l'intermédiaire de deux portions de couches diélectriques 10 et 20. Les deux capacités ainsi formées, électriquement reliées par le reste de la couche conductrice CI1 forment donc la résistance R1.

On remarque par ailleurs que la forme de cette résistance R1 (plus précisément la forme d'une partie de la couche CI1) épouse partiellement la forme de la grille GTM2 du transistor de mémorisation TM2. Cette résistance a été réalisée de façon analogue à celle qui a été décrite en référence à la figure 3.

Ceci étant, en variante, il serait possible de déposer directement une couche d'un matériau résistif sur les deux couches LIL1 et LIL2, par exemple un matériau à base de nitrure de titane ou de tantale.

L'homme du métier remarque donc que les deux résistances R 1 et R2 sont au contact du niveau de métal 0 et s'étendent entre ce niveau de métal 0 et le niveau de métal 1.

On obtient donc un point mémoire particulièrement compact qui évite la réalisation des résistances à l'extérieur des zones actives des transistors et qui permet ainsi une réduction de surface de l'ordre de 30% environ.

**Revendications**

1. Dispositif intégré de mémoire vive statique à quatre transistors et deux résistances, dans lequel les quatre transistors sont réalisés dans un substrat semiconducteur et mutuellement interconnectés par une couche d'interconnexion locale (M0) située sous un premier niveau de métallisation (M1) et formant au dessus du substrat un niveau de métallisation de base (M0), et les deux résistances s'étendent au contact d'une partie (LIL1, LIL2) de la couche d'interconnexion locale entre le niveau de métallisation de base (M0) et le premier niveau de métallisation (M1).

2. Dispositif selon la revendication 1, caractérisé par le fait que chaque résistance est formée d'une couche (CI) d'un matériau électriquement conducteur reposant à ses deux extrémités sur deux portions de la couche d'interconnexion locale, et de deux fine couches (10, 20) d'un matériau diélectrique respectivement disposées au deux extrémités de la couche électriquement conductrice (CI) entre cette couche électriquement conductrice et la portion correspondante (LIL1, LIL2) de la couche d'interconnexion locale.

3. Dispositif selon la revendication 1, caractérisé par le fait que chaque résistance est formée d'une couche d'un matériau résistif reposant à ses deux extrémités sur deux portions (LIL1, LIL2) de la couche d'interconnexion locale.

4. Dispositif selon l'une des revendications précédentes, caractérisé par le fait que chaque résistance s'appuie sur une première portion (LIL2) de couche d'interconnexion locale réalisant l'interconnexion entre la grille d'un transistor de mémorisation et le drain de l'autre transistor de mémorisation, et sur une deuxième portion (LIL1) de couche d'interconnexion locale reliée au premier niveau de métallisation (PM3) par un trou d'interconnexion métallique, et par le fait que la forme de chaque résistance épouse partiellement celle de ladite grille (GTM2) dudit transistor de mémorisation.

5. Procédé de réalisation d'un circuit intégré comprenant une résistance disposée entre deux niveaux de métallisation du circuit intégré, dans lequel on réalise sur le niveau de métallisation inférieur ($M_n$) un niveau de métallisation intermédiaire ($M_{n+1/2}$) comportant une couche électriquement conductrice (CI), dont la face inférieure d'une première partie (11) repose au dessus d'une portion d'une piste métallique ($P1_n$) du niveau de métallisation inférieur par l'intermédiaire d'une fine couche d'un matériau diélectrique (CD) de façon à former au moins une première partie de ladite résistance, cette couche conductrice étant entourée latéralement d'une couche isolante intermédiaire (ISI), on dépose sur le niveau de métallisation intermédiaire une couche isolante supérieure (ISS) supportant le niveau de métallisation supérieur, et on réalise une connexion métallique ($VA2_{n+1}$) reliant une deuxième partie (12) de la couche conductrice à une piste du niveau de métallisation supérieur.

6. Procédé selon la revendication 5, caractérisé par le fait que les première et deuxième parties (11, 12) sont identiques et par le fait que la réalisation de la connexion métallique ($VA2_{n+1}$) comporte la gravure de la couche isolante supérieure avec arrêt sur la face supérieure de la deuxième partie de la couche conductrice.

7. Procédé selon la revendication 5, caractérisé par le fait que la deuxième partie (12) est déportée par rapport à ladite première partie (11).

8. Procédé selon la revendication 7, caractérisé par le fait que la réalisation de la connexion métallique ($VA2_{n+1}$) comporte la gravure de la couche isolante supérieure avec arrêt sur la face supérieure de la deuxième partie de la couche conductrice.

9. Procédé selon la revendication 7, caractérisé par le fait que la face inférieure de la deuxième partie (12) de la couche conductrice se situe au contact de ladite couche diélectrique au dessus d'une portion d'une autre piste métallique ($P2_n$) du niveau inférieur, de façon à former une deuxième partie de la résistance électriquement reliée à la première partie par ladite couche conductrice, et par le fait que la connexion métallique est en contact avec une autre portion de ladite autre piste métallique du niveau inférieur.

10. Procédé selon l'une des revendications 5 à 9, caractérisé par le fait que la réalisation du niveau de métallisation intermédiaire comprend le dépôt de la couche isolante intermédiaire (ISI), la gravure de cette couche isolante de façon à définir une cavité (CAV) à l'emplacement de ladite couche conductrice, le dépôt de la couche diélectrique (CD) dans la cavité, puis le remplissage de ladite cavité avec un matériau électriquement conducteur de façon à former ladite couche conductrice (CI).

**FIG.1**

EP 1 011 136 A1

## FIG.2

CIT

$M_{n+1}$ → | P3$_{n+1}$ | P2$_{n+1}$ | IS$_{n+1}$

ISS

ISI

$M_{n+1/2}$ → CI    CD

$M_n$ → P3$_n$    P1$_n$    IS$_n$

GR3    VA3$_{n+1}$    CAV    GR2    10    11,12    VA2$_{n+1}$

## FIG.3

CIT

$M_{n+1}$ → | $P3_{n+1}$ | $IS_{n+1}$

ISS

$M_{n+1/2}$ → | CI | ISI
| | CD

$M_n$ → | $P3_n$ | $P1_n$ | $P2_n$ | $IS_n$

10   11   13   20   12

GR3   $VA3_{n+1}$   CAV

# FIG.4

EP 1 011 136 A1

FIG.5

FIG.6

**Office européen des brevets**

## RAPPORT DE RECHERCHE EUROPEENNE

Numéro de la demande

EP 99 40 3122

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | WO 84 03587 A (ADVANCED MICRO DEVICES INC) 13 septembre 1984 (1984-09-13) | 1,5 | H01L21/768 |
| A | * abrégé; figure 2H * | 7 | |
| A | US 4 146 902 A (TANIMOTO MASAFUMI ET AL) 27 mars 1979 (1979-03-27) * figure 13 * | 1,5,6 | |
| A | US 5 665 629 A (STARKEY GORDEN SETH ET AL) 9 septembre 1997 (1997-09-09) * abrégé; figures 4A-4E * | 1,2,5 | |
| A | WO 98 18158 A (ADVANCED MICRO DEVICES INC) 30 avril 1998 (1998-04-30) * abrégé; figures 3-6 * | 1 | |
| A | US 5 177 030 A (MANNING MONTE ET AL) 5 janvier 1993 (1993-01-05) * abrégé; figure 8 * | 1 | |
| A | DE 38 13 836 A (LICENTIA GMBH) 2 novembre 1989 (1989-11-02) * colonne 2, ligne 15 - colonne 3, ligne 55; figures 1A-2D * | 1 | DOMAINES TECHNIQUES RECHERCHES (Int.Cl.7) H01L |

Le présent rapport a été établi pour toutes les revendications

| Lieu de la recherche | Date d'achèvement de la recherche | Examinateur |
|---|---|---|
| LA HAYE | 21 février 2000 | Königstein, C |

EP 1 011 136 A1

**ANNEXE AU RAPPORT DE RECHERCHE EUROPEENNE
RELATIF A LA DEMANDE DE BREVET EUROPEEN NO.**

EP 99 40 3122

La présente annexe indique les membres de la famille de brevets relatifs aux documents brevets cités dans le rapport de recherche européenne visé ci-dessus.
Lesdits membres sont contenus au fichier informatique de l'Office européen des brevets à la date du
Les renseignements fournis sont donnés à titre indicatif et n'engagent pas la responsabilité de l'Office européen des brevets.

21-02-2000

| Document brevet cité au rapport de recherche | | Date de publication | Membre(s) de la famille de brevet(s) | | Date de publication |
|---|---|---|---|---|---|
| WO 8403587 | A | 13-09-1984 | US | 4569122 A | 11-02-1986 |
| | | | EP | 0136350 A | 10-04-1985 |
| US 4146902 | A | 27-03-1979 | JP | 1111810 C | 16-09-1982 |
| | | | JP | 52067532 A | 04-06-1977 |
| | | | JP | 57004038 B | 23-01-1982 |
| | | | CA | 1082809 A | 29-07-1980 |
| | | | DE | 2653724 A | 30-06-1977 |
| | | | FR | 2334201 A | 01-07-1977 |
| | | | NL | 7613428 A,B, | 07-06-1977 |
| US 5665629 | A | 09-09-1997 | AUCUN | | |
| WO 9818158 | A | 30-04-1998 | US | 5804470 A | 08-09-1998 |
| | | | EP | 0958599 A | 24-11-1999 |
| US 5177030 | A | 05-01-1993 | US | 5241206 A | 31-08-1993 |
| DE 3813836 | A | 02-11-1989 | EP | 0340497 A | 08-11-1989 |
| | | | US | 5066605 A | 19-11-1991 |

EPO FORM P0460

Pour tout renseignement concernant cette annexe : voir Journal Officiel de l'Office européen des brevets, No.12/82

13